# EUROPÄISCHE PATENTSCHRIFT

(11) **EP 3 165 284 B1**
(45) Veröffentlichungstag und Bekanntmachung des Hinweises auf die Patenterteilung: **21.07.2021**
(21) Anmeldenummer: 16195486.2
(22) Anmeldetag: 25.10.2016
(51) Int. Cl.: B02C 7/13

(54) **ZERKLEINERUNGSZAHNSCHEIBE FÜR EINEN KÖRNERPROZESSOR**
REFINER DISK FOR A CORN GRINDER
DISQUE POUR BROYEUR DE GRAINS

(30) Priorität: 04.11.2015 AT 5019715 U
(43) Veröffentlichungstag der Anmeldung: 10.05.2017
(73) Patentinhaber: Gebrüder Busatis Gesellschaft m.b.H., 3251 Purgstall an der Erlauf (AT)
(72) Erfinder: Lutz, Wolfgang, 3250 Wieselburg (AT); Nadlinger, Markus, 3324 Euratsfeld (AT); Scharner, Harald, 3251 Purgstall (AT)
(74) Vertreter: Puchberger & Partner Patentanwälte

(56) Entgegenhaltungen:
- EP-A1- 0 480 851
- WO-A1-86/00546
- FR-A- 1 024 928
- US-A- 5 165 592

## Beschreibung

Die Erfindung betrifft eine Zerkleinerungszahnscheibe für einen Körnerprozessor mit jeweils eine nachlaufende Zahnflanke, einen sogenannten Zahnrücken, und eine vorauseilende Zahnflanke, eine sogenannte Zahnbrust, aufweisenden Zähnen an ihrer Oberfläche, wobei die Zähne im Bereich des Zahnrückens eine durchgehende oder in Teilzonen aufgeteilte Verschleißschutzzone aufweisen, deren Verschleißwiderstand größer ist als der des Materials des Grundkörpers der Zerkleinerungszahnscheibe. Die Erfindung betrifft ferner ein Verfahren zum Herstellen einer Zerkleinerungszahnscheibe für einen Körnerprozessor mit Zähnen an ihrer Oberfläche. Eine Zerkleinerungszahnscheibe ist z.B. aus WO-A-8600546 bekannt.

Bei Erntemaschinen für Mais und Ganzpflanzen sowohl als Futtermittel als auch für Biogasanlagen wird das Erntegut nach dem Schneiden und Häckseln durch eine Zerkleinerungsvorrichtung, dem sogenannten Körnerprozessor, mit Zerkleinerungszahnwalzen oder -scheiben geführt, die ein Aufbrechen der Körner bewirkt und damit den Aufschluss des Ernteguts erlaubt. Gleichzeitig dient die Zerkleinerungsvorrichtung zur Förderung des Ernteguts. Im Falle von Körnerprozessoren mit Zerkleinerungszahnwalzen wird das gehäckselte Erntegut einem Paar zylindrischer Walzen mit an ihrer Oberfläche vorgesehenen Zähnen zugeführt. Die beiden Walzen rotieren gegenläufig, wobei eine der Walzen eine höhere Rotationsgeschwindigkeit, z.B. um 20% erhöht, hat. Um die Funktion des Aufbrechens der Körner als auch die Funktion der Förderung des Ernteguts gut erfüllen zu können, muss der Abstand zwischen den im Reibspalt einander gegenüberliegenden Zahnkanten der beiden Walzen über die gesamte Länge und in jeder beliebigen Drehstellung in einem engen vorgegebenen Bereich, z.B. für Mais zwischen 0,5 und 3,0 mm, liegen. Durch die Arbeit tritt an den Zahnkanten ein Verschleiß auf, der zu einer Abrundung der Zahnkanten führt. Dadurch vergrößert sich der Abstand zwischen den Zahnkanten im Spalt der beiden Walzen und die Funktion des Aufbrechens der Körner geht verloren. Ferner sind Körnerprozessoren bekannt, bei denen auf zwei parallelen Wellen jeweils mehrere Zerkleinerungszahnscheiben aneinandergereiht sind. Die Scheiben bilden im Schnitt durch die Achsen ihrer Aufreihung eine nicht gerade Außenkontur. Diese Außenkontur einer Scheibenreihe greift dabei in die Außenkontur der anderen Scheibenreihe derart ein, dass ein paralleler Reibspalt zwischen den Scheibenreihen entsteht. Derart nicht gerade verlaufende Reibspaltkonturen bei Zerkleinerungszahnscheiben erlauben eine Vergrößerung der Reibfläche und somit besseren Körneraufschluss im Vergleich zum geraden Reibspalt bei Zerkleinerungszahnwalzen. Das gehäckselte Erntegut wird zwischen den beiden Scheibenreihen entsprechend hindurchgefördert und dabei die Körner aufgebrochen und das Erntegut gefördert. Vorteil der Zerkleinerungszahnscheiben ist, dass bei verstärkter Abnutzung in einem Bereich entlang der Aneinanderreihungsachse nur die Scheiben in diesem Bereich ausgetauscht werden können. Zur Verringerung des Verschleißes ist es derzeit bekannt, die Zerkleinerungszahnscheiben hartzuverchromen, zu nitrieren oder zu borieren. Alle diese Verfahren sind einerseits sehr teuer und andererseits sind die Standzeiten unzureichend. Aus der WO 86/00546 ist es bekannt, Zerkleinerungszahnscheiben mit Hilfe von Hochenergiestrahlverfahren zu bearbeiten und deren Oberflächenbeschaffenheit damit zu optimieren.

Aufgabe der vorliegenden Erfindung ist es, eine Zerkleinerungszahnscheibe zu schaffen, mit deren Einsatz kostengünstiger gearbeitet werden kann, d.h. deren Herstellung kostengünstiger ist und/oder deren Standzeit noch höher ist, und ein Verfahren zur Herstellung dieser Zerkleinerungszahnscheibe zu finden. Die Oberflächenbeständigkeit gegen mechanische Einflüsse soll erhöht werden, wobei die Zahnstruktur möglichst erhalten bleibt.

Dazu ist eine erfindungsgemäße Zerkleinerungszahnscheibe für einen Körnerprozessor mit jeweils eine nachlaufende Zahnflanke, einen sogenannten Zahnrücken, und eine vorauseilende Zahnflanke, eine sogenannte Zahnbrust, aufweisenden Zähnen an ihrer Oberfläche, wobei die Zähne im Bereich des Zahnrückens eine durchgehende oder in Teilzonen aufgeteilte Verschleißschutzzone aufweisen, deren Verschleißwiderstand größer ist als der des Materials des Grundkörpers der Zerkleinerungszahnscheibe, dadurch gekennzeichnet, dass der Grundkörper eine die Form der Zähne bestimmende Zahnstruktur hat und die Verschleißschutzzone unter im Wesentlichen Beibehaltung der Geometrie der Zahnstruktur durch ein Hochenergiestrahlverfahren hergestellt ist. Hochenergiestrahlverfahren zeichnen sich durch eine hohe Energiedichte aus, sodass bei der Herstellung der Verschleißschutzzone eine kurze Einwirkzeit des Hochenergiestrahls genügt und das Material des Grundkörpers nur an der Oberfläche bzw. in sehr oberflächennahen Bereichen bis etwa 1 mm beeinflusst wird. Insbesondere kommt es durch das Hochenergiestrahlverfahren bei einem vorgehärteten Grundmaterial im Bereich der Wärmeeinflusszone nur zu einem geringen Härteabfall. Ist das Grundmaterial nicht gehärtet, kommt es durch die geringe Eindringtiefe zur raschen Abkühlung und damit zu einer Aufhärtung des Grundmaterials und somit zu einer Stützwirkung für die Verschleißschutzzone. Durch das Hochenergiestrahlverfahren wird eine Verschleißschutzzone hergestellt, die zu einer beachtlichen Standzeitverlängerung führt, wobei die Form der Zähne durch das Hochenergiestrahlverfahren im Wesentlichen nicht mehr verändert wird. Durch diese endkonturnahe Bearbeitung ist ein guter Erhalt der Zahnkanten möglich und eine Nachbearbeitung nicht erforderlich.Die Verschleißschutzzone ist erfindungsgemäß eine durch ein Auftragsschweißverfahren aufgebrachte Hartstoffbeschichtung. Da bei Hochenergiestrahlverfahren der Energieeintrag in das Grundmaterial nur in sehr oberflächennahe Bereichen bis etwa 1 mm erfolgt und die aufgetragene Beschichtungsdicke sehr gering ist, nämlich 0,05 bis maximal 0,5 mm, bevorzugt 0,1 bis 0,4 mm, besonders bevorzugt 0,2 bis 0,3 mm ist, kommt es zu keiner wesentlichen Veränderung der Form der Zähne.

Vorzugsweise ist dabei die Verschleißschutzzone partiell, unter gänzlicher oder teilweiser Aussparung der Zahnbrust hergestellt. Ist die Verschleißschutzzone nur auf der der Zahnkante beim Zerkleinerungsprozess nachlaufenden Zahnflanke (Zahnrücken) vorgesehen, oder weist die Verschleißschutzzone zumindest im Bereich der Zahnkante auf der Zahnbrust eine Aussparung auf, ergibt sich durch den Verschleiß des Grundmaterials auf der vorauseilenden Zahnflanke (Zahnbrust) ein Selbstschärfeeffekt.

Gemäß Ausführungsformen der Erfindung ist der vom Zahnrücken und der Zahnbrust eingeschlossene Zahnflankenwinkel im Bereich von 45° bis 135°, vorzugsweise von 60° bis 120°, besonders bevorzugt 90° ausgeführt.

Vorteilhafterweise hat die Verschleißschutzzone einen Verschleißwiderstand, der um mindestens 10% größer und vorzugsweise um mindestens 25% größer als der Verschleißwiderstand des Materials des Grundkörpers ist. Der Verschleißwiderstand bzw. die abrasive Verschleißbeständigkeit lässt sich dabei z.B. über das Reibradverfahren nach der Norm ASTM G65 bestimmen.

Die Verschleißschutzzone kann durch Gefügeumwandlung des Materials des Grundkörpers in einem Härtungs- oder Umschmelzverfahren hergestellt sein. In diesen Verfahren wird das Material des Grundkörpers selbst im oberflächennahen Bereich durch den Hochenergiestrahl ohne Zusatzwerkstoff verändert und damit der Verschleißwiderstand gesteigert.

Alternativ kann die Verschleißschutzzone durch Beschichtungs-, Auftragsschweiß-, Dispergier-, Legierungs- oder Einschmelzverfahren mittels Hochenergiestrahl hergestellt sein. Durch diese Verfahren wird ein Zusatzwerkstoff auf bzw. in die Oberfläche des Grundkörpers auf- bzw. eingebracht.

Die Verschleißschutzzone kann erfindungsgemäß Hartstoffteilchen enthalten. Durch kantige Hartstoffe kann, insbesondere bei großen Hartstoffteilchen, eine raue Oberfläche erzielt werden, die für ein gutes Erfassen des Ernteguts beim Aufbrechen und eine gute Förderwirkung auf den Erntegutstrom sorgt.

Die Ausbildung der rauen Oberfläche wird noch dadurch begünstigt, dass die Hartstoffteilchen durch den raschen Erstarrungsprozess aus dem Matrixmaterial herausragen.

Dabei enthält die durch ein Auftragsschweißverfahren aufgebrachte Hartstoffbeschichtung in vorteilhafter Weise in ein Matrixmaterial eingebettete Hartstoffteilchen mit einer Größe zwischen 40 und 250 µm, wobei das Matrixmaterial vorzugsweise Nickel, Kobalt oder eine Nickel-Chrom-Silizium-Verbindung enthält und die Hartstoffteilchen vorzugsweise Karbide, Nitride oder Oxide, besonders bevorzugt Wolframkarbide sind.

Der Grundkörper kann zumindest im Bereich der Zähne, insbesondere durch Randschichthärten, besonders bevorzugt durch induktives Härten, vorgehärtet oder nachträglich gehärtet sein.

Beim erfindungsgemäßen Verfahren zum Herstellen einer Zerkleinerungszahnscheibe für einen Körnerprozessor mit jeweils eine nachlaufende Zahnflanke, einen sogenannten Zahnrücken, und eine vorauseilende Zahnflanke, eine sogenannte Zahnbrust, aufweisenden Zähnen an ihrer Oberfläche, wobei die Zähne im Bereich des Zahnrückens eine durchgehende oder in Teilzonen aufgeteilte Verschleißschutzzone aufweisen, deren Verschleißwiderstand größer ist als der des Materials des Grundkörpers, wird der Grundkörper mit einer die Form der Zähne bestimmenden Zahnstruktur bereitgestellt und die Verschleißschutzzone wird unter im Wesentlichen Beibehaltung der Geometrie der Zahnstruktur durch ein Hochenergiestrahlverfahren hergestellt. Das Gefüge des Materials des Grundkörpers wird ohne Zusatzwerkstoff in einem Härtungs- oder Umschmelzverfahren umgewandelt. In einem Auftragsschweißverfahren wird der Grundkörper mittels Hochenergiestrahl mit einer Hartstoffbeschichtung beschichtet.

Vorzugsweise wird die Verschleißschutzzone partiell, unter gänzlicher oder teilweiser Aussparung der Zahnbrust hergestellt.

Alternativ wird mittels Beschichtungs-, Auftragsschweiß-, Dispergier-, Legierungs- oder Einschmelzverfahren ein Zusatzwerkstoff in bzw. auf den Grundkörper ein- bzw. aufgebracht.

Um die Erfindung besser zu verdeutlichen, wird sie anhand der beiliegenden Zeichnungen nochmals erläutert.

Dabei zeigt die Fig. 1a eine Draufsicht und die Fig. 1b einen vergrößerten Längsschnitt von auf zwei parallelen Wellen angeordneten Zerkleinerungszahnscheiben. Fig. 2 stellt schematisch einen Zahn im Bereich der Zahnkante dar. Fig. 3 zeigt einen Zahn mit Verschleißschutzzone am Zahnrücken. Die Figuren 4a und 4b zeigen zwei Varianten für die Ausbildung von Zähnen auf erfindungsgemäßen Zerkleinerungszahnscheiben.

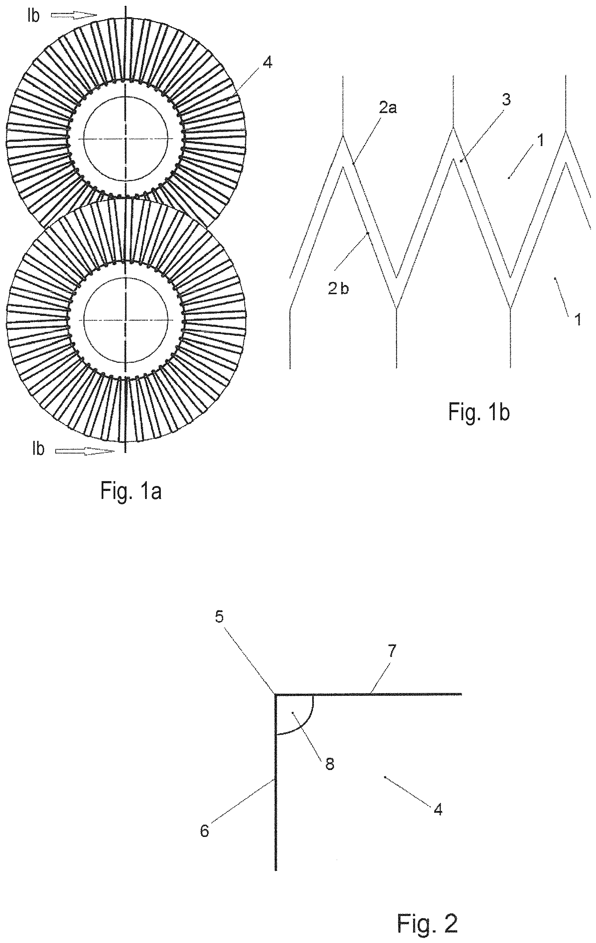

Fig. 1b zeigt den Längsschnitt der auf zwei parallelen Wellen aneinandergereihten Zerkleinerungszahnscheiben 1 mit Zähnen 4. Die Scheiben 1 bilden im Schnitt durch die Achsen ihrer Aufreihung eine nicht gerade Außenkontur 2a bzw. 2b. Die Außenkontur 2a einer Scheibenreihe greift dabei in die Außenkontur 2b der anderen Scheibenreihe derart ein, dass ein paralleler Reibspalt 3 zwischen den Scheibenreihen entsteht.

Fig. 2 zeigt einen Zahn 4 einer Zerkleinerungszahnscheibe 1 mit der Zahnkante 5, die aus einer vorauseilenden Zahnflanke, der sogenannten Zahnbrust 6 und einer nachlaufenden Zahnflanke, dem sogenannten Zahnrücken 7 über den Zahnflankenwinkel 8 gebildet wird.

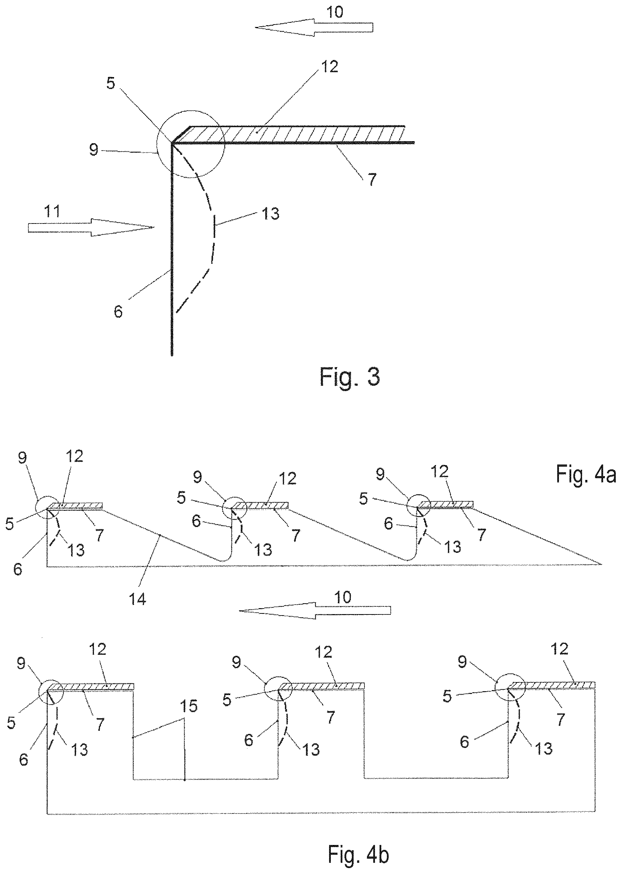

In Fig. 3 wird der Selbstschärfeeffekt 9 an der Zahnkante 5 mit dargestellter Bewegungsrichtung 10 und Angriffsrichtung 11 des Ernteguts, der am Zahnrücken 7 mit einer Verschleißschutzzone 12 versehen ist, dargestellt. Dieser wird durch den höheren Verschleiß 13 des Grundmaterials an der Zahnbrust 6 gegenüber dem Verschleiß an der Verschleißschutzzone 12 generiert.

Die Figuren 4a und 4b zeigen den Verschleiß 13 des Grundmaterials an der Zahnbrust 6 und den daraus resultierenden Selbstschärfeeffekt 9 an der Zahnkante 5 bei zwei bevorzugten Übergangsformen 14, 15 zwischen dem Zahnrücken 7 mit der Verschleißschutzzone 12 und der in Bewegungsrichtung 10 jeweils nachlaufenden Zahnbrust 6.

## Patentansprüche

1. Zerkleinerungszahnscheibe (1) für einen Körnerprozessor mit Zähnen (4) an ihrer Oberfläche, wobei die Zähne (4) jeweils eine nachlaufende Zahnflanke, einen Zahnrücken (7), und eine vorauseilende Zahnflanke, eine Zahnbrust (6), aufweisen wobei die Zähne (4) im Bereich des Zahnrückens (7), eine durchgehende oder in Teilzonen aufgeteilte Verschleißschutzzone (12) aufweisen, deren Verschleißwiderstand größer ist als der des Materials des Grundkörpers der Zerkleinerungszahnscheibe, wobei der Grundkörper eine die Form der Zähne (4) bestimmende Zahnstruktur hat und die Verschleißschutzzone (12) unter im Wesentlichen Beibehaltung der Geometrie der Zahnstruktur durch ein Hochenergiestrahlverfahren hergestellt ist, **dadurch gekennzeichnet,**
- **dass** die Verschleißschutzzone (12) eine durch ein Auftragsschweißverfahren aufgebrachte Hartstoffbeschichtung ist,
- und **dass** die Hartstoffbeschichtung eine Dicke von 0,05 bis 0,5 mm, bevorzugt von 0,1 bis 0,4 mm, besonders bevorzugt von 0,2 bis 0,3 mm hat.

2. Zerkleinerungszahnscheibe (1) nach Anspruch 1, **dadurch gekennzeichnet, dass** die Verschleißschutzzone (12) partiell, unter gänzlicher oder teilweiser Aussparung der Zahnbrust (6) hergestellt ist.

3. Zerkleinerungszahnscheibe nach Anspruch 1 oder 2, **dadurch gekennzeichnet, dass** der vom Zahnrücken (7) und der Zahnbrust (6) eingeschlossene Zahnflankenwinkel (8) im Bereich von 45° bis 135°, vorzugsweise von 60° bis 120°, besonders bevorzugt 90° ausgeführt ist.

4. Zerkleinerungszahnscheibe nach Anspruch 1, 2 oder 3, **dadurch gekennzeichnet, dass** der Verschleißwiderstand der Verschleißschutzzone (12) um mindestens 10% größer und vorzugsweise um mindestens 25% größer als der Verschleißwiderstand des Materials des Grundkörpers ist.

5. Zerkleinerungszahnscheibe nacheinem der Ansprüche 1 bis 4, **dadurch gekennzeichnet, dass** die Verschleißschutzzone (12) durch Gefügeumwandlung des Materials des Grundkörpers ohne Zusatzwerkstoff in einem Härtungs- oder Umschmelzverfahren hergestellt ist.

6. Zerkleinerungszahnscheibe nach einem der Ansprüche 1 bis 4, **dadurch gekennzeichnet, dass** die Verschleißschutzzone (12) durch Auf- oder Einbringen eines Zusatzwerkstoffes mittels Beschichtungs-, Auftragsschweiß-, Dispergier-, Legierungs- oder Einschmelzverfahren hergestellt ist.

7. Zerkleinerungszahnscheibe nach Anspruch 6, **dadurch gekennzeichnet, dass** die Verschleißschutzzone (12) Hartstoffteilchen enthält.

8. Zerkleinerungszahnscheibe nach einem der Ansprüche 1 bis 7, **dadurch gekennzeichnet, dass** die durch ein Auftragsschweißverfahren aufgebrachte Hartstoffbeschichtung in ein Matrixmaterial eingebettete Hartstoffteilchen mit einer Größe zwischen 40 und 250 µm enthält, wobei das Matrixmaterial vorzugsweise Nickel, Kobalt oder ein Nickel-Chrom-Silizium-Verbindung enthält und die Hartstoffteilchen vorzugsweise Karbide, Nitride oder Oxide, besonders bevorzugt Wolframkarbide sind.

9. Zerkleinerungszahnscheibe nach Anspruch 8, **dadurch gekennzeichnet, dass** die Hartstoffteilchen aus dem rasch erstarrtem Matrixmaterial herausragen und eine raue Oberfläche bilden.

10. Zerkleinerungszahnscheibe nach einem der vorgehenden Ansprüche, **dadurch gekennzeichnet, dass** der Grundkörper zumindest im Bereich der Zähne, insbesondere durch Randschichthärten, besonders bevorzugt durch induktives Härten, vorgehärtet oder nachträglich gehärtet ist.

11. Verfahren zum Herstellen einer Zerkleinerungszahnscheibe (1) für einen Körnerprozessor mit Zähnen (4) an ihrer Oberfläche, wobei die Zähne (4) jeweils eine nachlaufende Zahnflanke, einen Zahnrücken (7), und eine vorauseilende Zahnflanke, eine Zahnbrust (6), aufweisen, wobei die Zähne (4) im Bereich des Zahnrückens (7) eine durchgehende oder in Teilzonen aufgeteilte Verschleißschutzzone (12) aufweisen, deren Verschleißwiderstand größer ist als der des Materials des Grundkörpers, wobei der Grundkörper mit einer die Form der Zähne (4) bestimmenden Zahnstruktur bereit gestellt wird und die Verschleißschutzzone (12) unter im Wesentlichen Beibehaltung der Geometrie der Zahnstruktur durch ein Hochenergiestrahlverfahren hergestellt wird, **dadurch gekennzeichnet,**
- **dass** die Gefügeumwandlung des Materials des Grundkörpers ohne Zusatzwerkstoff in einem Härtungs- oder Umschmelzverfahren erfolgt,
- und **dass** in einem Auftragsschweißverfahren der Grundkörper mit einer Hartstoffbeschichtung beschichtet wird.

12. Verfahren nach Anspruch 11, **dadurch gekennzeichnet, dass** die Verschleißschutzzone (12) partiell, unter gänzlicher oder teilweiser Aussparung der Zahnbrust (6), hergestellt wird.

13. Verfahren nach Anspruch 12, **dadurch gekennzeichnet, dass** mittels Beschichtungs-, Auftragsschweiß-, Dispergier-, Legierungs- oder Einschmelzverfahren ein Zusatzwerkstoff in bzw. auf den Grundkörper ein- bzw. aufgebracht wird.

## Claims

1. A toothed crushing disk (1) for a grain processor with teeth (4) on its surface, wherein each of the teeth (4) has a trailing tooth flank, a tooth back (7), and a leading tooth flank, a tooth face (6), wherein, in the area of the tooth back (7), the teeth (4) have a continuous wear protection zone (12) or a wear protection zone divided into sub-zones, whose wear resistance is bigger than that of the material of the base body of the toothed crushing disc, wherein the base body has a tooth structure determining the shape of the teeth (4) and wherein the wear protection zone (12) is produced by a high-energy beam process while substantially retaining the geometry of the tooth structure, **characterized**
- **in that** the wear protection zone (12) is a hard material coating applied by a deposition welding process,
- and **in that** the hard material coating has a thickness of 0.05 to 0.5 mm, preferably of 0.1 to 0.4 mm, particularly preferably of 0.2 to 0.3 mm.

2. The toothed crushing disk (1) according to claim 1, **characterized in that** the wear protection zone (12) is produced partially, leaving out the tooth face (6) completely or partially.

3. The toothed crushing disk according to claim 1 or 2, **characterized in that** the tooth flank angle (8) enclosed by the tooth back (7) and the tooth face (6) is in the range of 45° to 135°, preferably 60° to 120°, particularly preferably 90°.

4. The toothed crushing disk according to claim 1, 2 or 3, **characterized in that** the wear resistance of the wear protection zone (12) is bigger than the wear resistance of the material of the base body by at least 10 % and preferably by at least 25 %.

5. The toothed crushing disk according to one of claims 1 to 4, **characterized in that** the wear protection zone (12) is produced by structural transformation of the material of the base body without any additional material in a hardening or remelting process.

6. The toothed crushing disk according to one of claims 1 to 4, **characterized in that** the wear protection zone (12) is produced by applying or introducing an additional material by means of a coating, deposition welding, dispersion, alloying or remelting process.

7. The toothed crushing disk according to claim 6, **characterized in that** the wear protection zone (12) contains hard material particles.

8. The toothed crushing disk according to one of claims 1 to 7, **characterized in that** the hard material coating applied by a deposition welding process contains hard material particles embedded in a matrix material and having a size between 40 and 250 µm, the matrix material preferably containing nickel, cobalt or a nickel-chromium-silicon compound and the hard material particles preferably being carbides, nitrides or oxides, particularly preferably tungsten carbides.

9. The toothed crushing disk (1) according to claim 8, **characterized in that** the hard material particles protrude from the rapidly solidified matrix material and form a rough surface.

10. The toothed crushing disk according to one of the preceding claims, **characterized in that** the base body is prehardened or subsequently hardened at least in the area of the teeth, in particular by surface hardening, particularly preferably by inductive hardening.

11. A method for producing a toothed crushing disk (1) for a grain processor with teeth (4) on its surface, wherein each of the teeth (4) has a trailing tooth flank, a tooth back (7), and a leading tooth flank, a tooth face (6), wherein, in the area of the tooth back (7), the teeth (4) have a continuous wear protection zone (12) or a wear protection zone divided into sub-zones, whose wear resistance is bigger than that of the material of the base body, wherein the base body is provided with a tooth structure determining the shape of the teeth (4) and wherein the wear protection zone (12) is produced by a high-energy beam process while substantially retaining the geometry of the tooth structure, **characterized**
- **in that** the structural transformation of the material of the base body is carried out without an additional material in a hardening or remelting process,
- and **in that** the base body is coated with a hard material coating in a deposition welding process.

12. The method according to claim 11, **characterized in that** the wear protection zone (12) is produced partially, leaving out the tooth face (6) completely or partially.

13. The method according to claim 12, **characterized in that** an additional material is introduced into or applied to the base body by means of a coating, deposition welding, dispersion, alloying or remelting process.

## Revendications

1. Un disque denté de broyage (1) pour un appareil de traitement des grains avec des dents (4) sur sa surface, les dents (4) présentant chacune un profil de dent arrière, un dos de dent (7), et un profil de dent avant, une face d'attaque (6), les dents (4) présentant, dans la région du dos de dent (7), une zone de protection contre l'usure (12) continue ou divisée en zones partielles, dont la résistance à l'usure est supérieure à celle du matériau du corps de base du disque denté de broyage, le corps de base présentant une structure de dent qui détermine la forme des dents (4), et la zone de protection contre l'usure (12) étant produite par un procédé à faisceau à haute énergie tout en conservant sensiblement la géométrie de la structure de dent, **caractérisé**
- **en ce que** la zone de protection contre l'usure (12) est un revêtement en matériau dur appliqué par un procédé de rechargement par soudage,
- et **en ce que** le revêtement en matériau dur a une épaisseur de 0,05 à 0,5 mm, de préférence de 0,1 à 0,4 mm, de manière particulièrement préférée de 0,2 à 0,3 mm.

2. Le disque denté de broyage (1) selon la revendication 1, **caractérisé en ce que** la zone de protection contre l'usure (12) est réalisée partiellement, en épargnant la face d'attaque (6) complètement ou partiellement.

3. Le disque denté de broyage selon la revendication 1 ou 2, **caractérisé en ce que** l'angle de profil de dent (8) entre le dos de dent (7) et la face d'attaque (6) est conçu dans la gamme de 45° à 135°, de préférence de 60° à 120°, de manière particulièrement préférée 90°.

4. Le disque denté de broyage selon la revendication 1, 2 ou 3, **caractérisé en ce que** la résistance à l'usure de la zone de protection contre l'usure (12) est supérieure d'au moins 10 % et de préférence d'au moins 25 % à la résistance à l'usure du matériau du corps de base.

5. Le disque denté de broyage selon l'une des revendications 1 à 4, **caractérisé en ce que** la zone de protection contre l'usure (12) est produite par transformation structurelle du matériau du corps de base sans matériau additif dans un procédé de durcissement ou de refonte.

6. Le disque denté de broyage selon l'une des revendications 1 à 4, **caractérisé en ce que** la zone de protection contre l'usure (12) est réalisée par application ou introduction d'un matériau additif au moyen d'un procédé de revêtement, de rechargement par soudage, de dispersion, d'alliage ou de fusion.

7. Le disque denté de broyage selon la revendication 6, **caractérisé en ce que** la zone de protection contre l'usure (12) comprend des particules de matériau dur.

8. Le disque denté de broyage selon l'une des revendications 1 à 7, **caractérisé en ce que** le revêtement en matériau dur appliqué par un procédé de rechargement par soudage comprend des particules de matériau dur noyées dans un matériau de matrice et ayant une taille comprise entre 40 et 250 µm, dans lequel le matériau de matrice comprend de préférence du nickel, du cobalt ou un composé nickel-chrome-silicium et les particules de matériau dur sont de préférence des carbures, des nitrures ou des oxydes, de manière particulièrement préférée des carbures de tungstène.

9. Le disque denté de broyage selon la revendication 8, **caractérisé en ce que** les particules de matériau dur font saillie du matériau de matrice rapidement solidifié et forment une surface rugueuse.

10. Le disque denté de broyage selon l'une des revendications précédentes, **caractérisé en ce que** le corps de base est pré-durci ou durci ultérieurement au moins dans la zone des dents, en particulier par durcissement superficiel, de manière particulièrement préférée par durcissement par induction.

11. Un procédé de fabrication d'un disque denté de broyage (1) pour un appareil de traitement des grains avec des dents (4) sur sa surface, les dents (4) présentant chacune un profil de dent arrière, un dos de dent (7), et un profil de dent avant, une face d'attaque (6), les dents (4) présentant, dans la région du dos de dent (7), une zone de protection contre l'usure (12) continue ou divisée en zones partielles, dont la résistance à l'usure est supérieure à celle du matériau du corps de base, le corps de base étant pourvu d'une structure de dent qui détermine la forme des dents (4), et la zone de protection contre l'usure (12) étant produite par un procédé à faisceau à haute énergie tout en conservant sensiblement la géométrie de la structure de dent, **caractérisé**
- **en ce que** la transformation structurelle du matériau du corps de base est effectuée sans matériau additif dans un procédé de durcissement ou de refonte,
- et **en ce que** le corps de base est recouvert d'un revêtement en matériau dur dans un procédé de rechargement par soudage.

12. Le procédé selon la revendication 11, **caractérisé en ce que** la zone de protection contre l'usure (12) est réalisée partiellement, en épargnant la face d'attaque (6) complètement ou partiellement.

13. Le procédé selon la revendication 12, **caractérisé en ce qu'**un matériau additif est introduit dans ou appliqué sur le corps de base au moyen de procédés de revêtement, de rechargement par soudage, de dispersion, d'alliage ou de fusion.
